# EUROPEAN PATENT APPLICATION

(11) **EP 4 191 309 A1**
(43) Date of publication of application: **07.06.2023**
(21) Application number: 20950922.3
(22) Date of filing: 31.08.2020
(51) Int. Cl.: G02B 6/43, H01L 23/10

(54) **OPTOELECTRONIC APPARATUS AND OPTOELECTRONIC INTEGRATION METHOD**

(71) Applicant: Huawei Technologies Co., Ltd., Shenzhen, Guangdong 518129 (CN)
(72) Inventor: ZHANG, Shengli, Shenzhen, Guangdong 518129 (CN); TANG, Fusheng, Shenzhen, Guangdong 518129 (CN); WANG, Siqi, Shenzhen, Guangdong 518129 (CN)
(74) Representative: Goddar, Heinz J.
(86) International application number: PCT/CN2020/112690
(87) International publication number: WO 2022/041253

(57) **Abstract**

An optoelectronic apparatus (200) and an optoelectronic integration method , so that bandwidth for signal transmission can be improved, and signal transmission performance is improved. The optoelectronic apparatus (200) includes: a printed circuit board PCB (201), where a first substrate (203) and a second substrate (205) are separately disposed on the PCB (201), an application specific integrated circuit ASIC (202) is disposed on the first substrate (203), and an optoelectronic component (204) is disposed on the second substrate (205); and a flexible printed circuit FPC (206), where a first end of the FPC (206) is disposed on an upper surface of the first substrate (203) and is electrically connected to the ASIC (202), and a second end of the FPC (206) is disposed on the second substrate (205) and is electrically connected to the optoelectronic component (204).

## Description

### TECHNICAL FIELD

This application relates to the optical communication field, and more specifically, to an optoelectronic apparatus and an optoelectronic integration method in the optical communication field.

### BACKGROUND

With the development of an optical transmission product towards a higher transmission rate, the market imposes a higher bandwidth requirement on packaging and interconnection bandwidth of an optoelectronic component. To ensure reliable working of the optoelectronic component, the optoelectronic component is usually packaged in airtight ceramic. Therefore, a high-speed signal of the optoelectronic component needs to be connected, by using a flexible printed circuit (flexible printed circuit, FPC) and a circuit cable on a printed circuit board (printed circuit board, PCB), to an application specific integrated circuit (application specific integrated circuit, ASIC) disposed on the PCB.

However, an existing optoelectronic component and the ASIC need to be electrically connected to each other on a cable on the PCB. When a signal is transmitted between the optoelectronic component and the ASIC, a passive link experienced by signal transmission is relatively long. Consequently, loss of the signal in a transmission process is relatively large and there are a relatively large quantity of parasitic parameters, and therefore, bandwidth for signal transmission is limited. In addition, because a dielectric constant of the FPC and a dielectric constant of a material of a ceramic package differ to a relatively large extent, when the FPC is connected to the optoelectronic component, a packaging mode mismatch usually occurs, and therefore, bandwidth for signal transmission is also limited.

### SUMMARY

Based on an optoelectronic apparatus and an optoelectronic integration method provided in embodiments of this application, bandwidth for signal transmission can be improved, and signal transmission performance is improved.

According to a first aspect, an embodiment of this application provides an optoelectronic apparatus, including a PCB, an ASIC, a first substrate, an optoelectronic component, a second substrate, and an FPC. The first substrate and the second substrate are separately disposed on the PCB. The ASIC is disposed on the first substrate. The optoelectronic component is disposed on the second substrate. A first end of the FPC is disposed on an upper surface of the first substrate and is electrically connected to the ASIC, and a second end of the FPC is disposed on the second substrate and is electrically connected to the optoelectronic component.

Based on the optoelectronic apparatus provided in this embodiment of this application, the ASIC and the optoelectronic component may be electrically connected directly by using a circuit cable on the FPC. In other words, a signal of the optoelectronic component may be directly transmitted, by using the circuit cable on the FPC, to the ASIC disposed on the PCB without using the PCB, so that a length of a passive link experienced by signal transmission and a quantity of soldering nodes can be reduced. In this way, parasitic parameters of the signal in a transmission process can be reduced, and loss of the signal can be reduced. Therefore, bandwidth for signal transmission can be improved, and signal transmission performance is improved.

Optionally, there may be a plurality of types of optoelectronic components. This is not limited in this embodiment of this application.

In a possible implementation, the optoelectronic component may be an optoelectronic chip, and the optoelectronic chip is a core component of optical communication. For example, the optoelectronic chip may be a module that has an optoelectronic signal conversion function. In addition, the optoelectronic chip may further have a function such as modulation. For details, refer to the prior art. This is not specifically limited in this embodiment of this application.

In a possible implementation, that the ASIC is disposed on the first substrate may be understood as that the ASIC is packaged or mounted on the first substrate.

Optionally, the ASIC may be packaged on the first substrate in a plurality of manners. This is not limited in this embodiment of this application.

In a possible implementation, the ASIC and the first substrate may be soldered by using a first ball grid array (ball grid array, BGA).

For example, a first pad is disposed on a lower surface of the ASIC, a second pad is disposed on an upper surface of the first substrate, and the first pad and the second pad are soldered by using the first BGA.

In a possible implementation, that the optoelectronic component is disposed on the second substrate may be understood as that the optoelectronic component is packaged or mounted on the second substrate.

Optionally, the second substrate may alternatively be a package base or a base. In this embodiment of this application, only the substrate is used as an example for description. However, this embodiment of this application is not limited thereto.

Optionally, the first end of the FPC may be electrically connected to the first substrate in a plurality of manners. This is not limited in this embodiment of this application.

In a possible implementation, the first end of the FPC is soldered to the first substrate.

For example, a third pad is disposed on the first substrate, a fourth pad is disposed on the first end of the FPC, and the third pad is soldered to the fourth pad.

Optionally, the first end of the FPC and the first substrate may be soldered by using a tin-based solder by using an existing PCB or FPC soldering process, for example, soldering process such as hot bar soldering or laser. This is not limited in this embodiment of this application.

In a possible implementation, the optoelectronic apparatus may further include a first bonding wire, and the first end of the FPC is electrically connected to the first substrate by using the first bonding wire.

For example, a fifth pad is disposed on the upper surface of the first substrate, a sixth pad is disposed on an upper surface of the first end of the FPC, and the fifth pad and the sixth pad are electrically connected by using the first bonding wire.

Optionally, the second end of the FPC may be electrically connected to the second substrate in a plurality of manners. This is not limited in this embodiment of this application.

In a possible implementation, the optoelectronic apparatus includes a third substrate, the second end of the FPC is disposed on an upper surface of the third substrate, the second substrate is disposed on a lower surface of the third substrate, the third substrate is configured to electrically connect the FPC to the optoelectronic component, and a difference between a dielectric constant of a material of the third substrate and a dielectric constant of a material of the FPC is less than a preset dielectric constant threshold.

In other words, the material of the third substrate is close to or the same as the material of the FPC.

For example, the upper surface of the third substrate is soldered to the second end of the FPC, the lower surface of the third substrate is soldered to the upper surface of the second substrate by using a second BGA, and the upper surface of the third substrate is electrically connected to the lower surface of the third substrate by using at least one through-hole.

It should be noted that the through-hole is also referred to as a plated hole. In a double-sided substrate and a multi-layer substrate, to connect printed wires between layers, a common hole, that is, a through-hole, is drilled at an intersection of wires that need to be connected to the layers.

It should be noted that in a conventional technology, because packaging of the FPC and the ceramic second substrate belong to a PCB/FPC packaging process, the dielectric constant of the material of the FPC and a material of the ceramic second substrate are relatively different differ to a relatively large extent. A packaging mode mismatch usually occurs when the FPC is connected to the optoelectronic component. Therefore, bandwidth for signal transmission is limited.

In this embodiment of this application, the material of the FPC is close to or the same as the material of the third substrate, so that a problem of limited bandwidth for signal transmission caused by a material difference between the FPC and the third substrate can be avoided. In addition, because the third substrate and the second substrate are inter-substrate packaging, a packaging process with higher precision such as solder ball flip chip (solder ball flip chip) or copper pillar flip chip (copper pillar flip chip) may be used, to absorb an assembly tolerance between different materials, so that a problem of limited bandwidth for signal transmission caused by a material difference between the third substrate and the second substrate can be avoided. Therefore, the third substrate is electrically connected to the FPC and the second substrate, so that bandwidth for signal transmission can be improved.

In a possible implementation, the optoelectronic apparatus may further include a second bonding wire, and the second end of the FPC is electrically connected to the second substrate by using the second bonding wire.

Based on the optoelectronic apparatus provided in this application, the FPC is connected to the second substrate by using the second bonding wire; in other words, a soldering process does not need to be used for connection, so that a problem of limited bandwidth for signal transmission caused by a material difference between the FPC and the second substrate in the conventional technology can be avoided.

It should be noted that the foregoing various provided connection manners between the first end of the FPC and the substrate and the connection manners between the second end of the FPC and the second substrate may be randomly combined. This is not limited in this embodiment of this application.

For example, the optoelectronic apparatus may further include a third bonding wire and a fourth bonding wire, the first end of the FPC is connected to the substrate by using the third bonding wire, and the second end of the FPC is connected to the second substrate by using the fourth bonding wire.

According to a second aspect, an embodiment of this application further provides an optoelectronic integration method, including:
Step 1: Mount an ASIC on a first substrate.
Step 2: Mount an optoelectronic component on a second substrate.
Step 3: Mount the first substrate and the second substrate on a PCB.
Step 4: Dispose a first end of the FPC on the first substrate and electrically connect the first end of the FPC to the ASIC on the first substrate.
Step 5: Dispose a second end of the FPC on the second substrate and electrically connect the second end of the FPC to the optoelectronic component on the second substrate.

According to a third aspect, an embodiment of this application further provides another optoelectronic apparatus, including a PCB, an ASIC, a first substrate, an optoelectronic component, a second substrate, an FPC, and a third substrate. The first substrate and the second substrate are separately disposed on the PCB. The application specific integrated circuit ASIC is disposed on the first substrate. The optoelectronic component is disposed on the second substrate. A first end of the FPC is disposed on an upper surface of the PCB and is electrically connected to the ASIC disposed on the first substrate. A first end of the bonding wire is disposed on a second end of the FPC, a second end of the bonding wire is disposed on an upper surface of the second substrate, and the bonding wire is configured to electrically connect the FPC to the optoelectronic component.

In other words, the optoelectronic component is connected to the FPC by using an interposer of the third substrate, and is electrically connected to the ASIC by using a circuit cable on the PCB by using the FPC, and a material of the third substrate is close to or the same as a material of the FPC. In this way, a problem of limited bandwidth for signal transmission caused by a material difference between the FPC and the second substrate can be avoided.

In a possible implementation, the upper surface of the third substrate is electrically connected to the second end of the FPC, the lower surface of the third substrate is electrically connected to the upper surface of the second substrate, and the upper surface of the third substrate is electrically connected to the lower surface of the third substrate by using at least one through-hole.

In a possible implementation, the upper surface of the third substrate is soldered to the second end of the FPC.

In a possible implementation, the lower surface of the third substrate and the upper surface of the second substrate are soldered by using a first ball grid array BGA.

In a possible implementation, the material of the FPC is an organic material, and a material of the second substrate is ceramic.

It should be noted that for each part in the optoelectronic apparatus provided in the third aspect and a connection manner of the parts, refer to corresponding descriptions in the first aspect. To avoid repetition, details are not described herein again.

According to a fourth aspect, an embodiment of this application further provides another optoelectronic integration method, including:
Step 1: Mount an ASIC on a first substrate.
Step 2: Mount an optoelectronic component on a second substrate.
Step 3: Mount the first substrate and the second substrate on a PCB.
Step 4: Dispose a first end of the FPC on an upper surface of the PCB, and electrically connect the first end of the FPC to the ASIC disposed on the first substrate.
Step 5: Electrically connect the upper surface of the third substrate to a second end of the FPC, where a difference between a dielectric constant of a material of the third substrate and a dielectric constant of a material of the FPC is less than a preset dielectric constant threshold.
Step 6: Electrically connect the lower surface of the third substrate to an upper surface of the second substrate.
Step 7: Punch at least one through-hole between the upper surface of the third substrate and the lower surface of the third substrate.

According to a fifth aspect, an embodiment of this application further provides another optoelectronic apparatus, including a PCB, an ASIC, a first substrate, an optoelectronic component, a second substrate, an FPC, and a fifth bonding wire. The first substrate and the second substrate are separately disposed on the PCB. The ASIC is disposed on the first substrate. The optoelectronic component is disposed on the second substrate. A first end of the FPC is disposed on an upper surface of the PCB and is electrically connected to the ASIC disposed on the first substrate. A first end of the fifth bonding wire is disposed on a second end of the FPC, a second end of the fifth bonding wire is disposed on an upper surface of the second substrate, and the fifth bonding wire is configured to electrically connect the FPC to the optoelectronic component.

In other words, the optoelectronic component is connected to the FPC by using the fifth bonding wire, and is electrically connected to the ASIC by using a circuit cable on the PCB by using the FPC. In this way, a problem of limited bandwidth for signal transmission caused by a material difference between the FPC and the second substrate can be avoided.

In a possible implementation, a material of the FPC is an organic material, and a material of the second substrate is ceramic.

It should be noted that for each part in the optoelectronic apparatus provided in the fifth aspect and a connection manner of the parts, refer to corresponding descriptions in the first aspect. To avoid repetition, details are not described herein again.

According to a sixth aspect, an embodiment of this application further provides another optoelectronic integration method, including:
Step 1: Mount an ASIC on a first substrate.
Step 2: Mount an optoelectronic component on a second substrate.
Step 3: Mount the first substrate and the second substrate on a PCB.
Step 4: Dispose a first end of the FPC on an upper surface of the PCB, and electrically connect the first end of the FPC to the ASIC disposed on the first substrate.
Step 5: Dispose a first end of a bonding wire on a second end of the FPC, and electrically connect the first end of the bonding wire to the FPC.
Step 6: Dispose a second end of the bonding wire on an upper surface of the second substrate, and electrically connect the second end of the bonding wire to the optoelectronic component disposed on the second substrate.

### BRIEF DESCRIPTION OF DRAWINGS

FIG. 1 is a schematic diagram of a structure of an optoelectronic apparatus 100 according to an embodiment of this application;
FIG. 2 is a schematic diagram of a structure of an optoelectronic apparatus 200 according to an embodiment of this application;
FIG. 3 is a schematic diagram (top view) of a connection between an ASIC and a first substrate according to an embodiment of this application;
FIG. 4 is a schematic diagram (side view) of a connection between an ASIC and a first substrate according to an embodiment of this application;
FIG. 5 is a schematic diagram of a structure of an optoelectronic apparatus 300 according to an embodiment of this application;
FIG. 6 is a schematic diagram (top view) of a connection between a first substrate and an FPC according to an embodiment of this application;
FIG. 7 is a schematic diagram (side view) of a connection between a first substrate and an FPC according to an embodiment of this application;
FIG. 8 is a schematic diagram of a structure of an optoelectronic apparatus 400 according to an embodiment of this application;
FIG. 9 is a schematic diagram (top view) of another connection between a first substrate and an FPC according to an embodiment of this application;
FIG. 10 is a schematic diagram (side view) of another connection between a first substrate and an FPC according to an embodiment of this application;
FIG. 11 is a schematic diagram of a structure of an optoelectronic apparatus 500 according to an embodiment of this application;
FIG. 12 is another schematic diagram of a structure of an optoelectronic apparatus 500 according to an embodiment of this application;
FIG. 13 is a schematic diagram of a structure of an optoelectronic apparatus 600 according to an embodiment of this application;
FIG. 14 is a schematic diagram of a structure of an optoelectronic apparatus 700 according to an embodiment of this application;
FIG. 15 is a schematic diagram of a structure of an optoelectronic apparatus 800 according to an embodiment of this application; and
FIG. 16 is a schematic diagram of a structure of an optoelectronic apparatus 900 according to an embodiment of this application.

### DESCRIPTION OF EMBODIMENTS

The following describes technical solutions of this application with reference to the accompanying drawings.

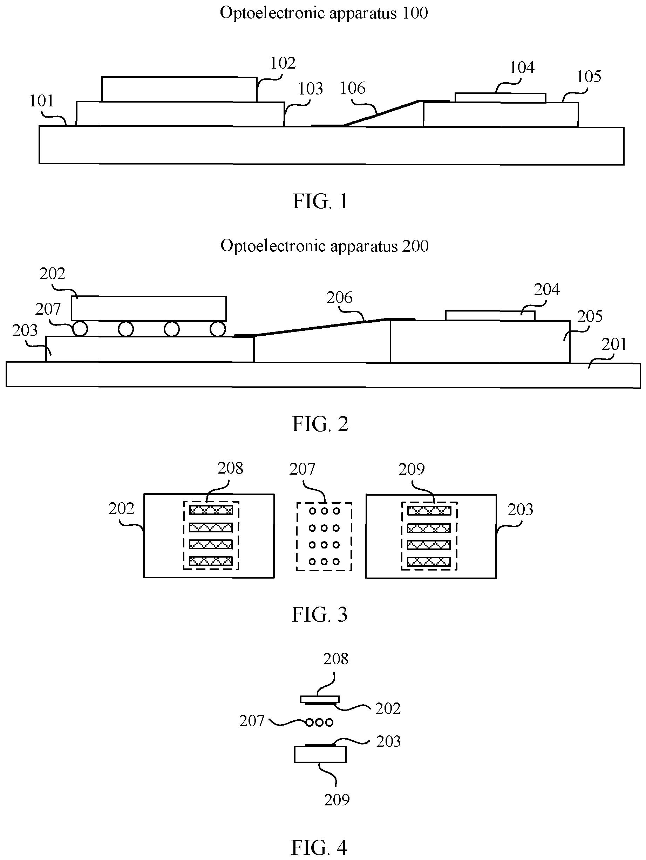

FIG. 1 is a schematic diagram (top view) of a structure of an optoelectronic apparatus 100 according to a conventional technology. As shown in FIG. 1, the optoelectronic apparatus 100 includes a PCB 101, an ASIC 102, a first substrate 103, an optoelectronic component 104, a second substrate 105, and an FPC 106. The first substrate 103 and the second substrate 105 are separately disposed on the PCB 101, the ASIC 102 is disposed on the first substrate 103, and the optoelectronic component 104 is disposed on the second substrate 105. A first end of the FPC 106 is disposed on an upper surface of the second substrate 105 and is electrically connected to the optoelectronic component 104, and a second end of the FPC 106 is disposed on an upper surface of the PCB 101 and is electrically connected to the ASIC 102.

However, in an existing optoelectronic apparatus 100 with an optoelectronic component, the ASIC 102 is electrically connected to the optoelectronic component 104 by using the PCB 101 and the FPC 106; in other words, a signal of the optoelectronic component 104 needs to use the FPC 106, and is transmitted, by using a circuit cable on the PCB 101, to the ASIC 102 disposed on the PCB101. When a signal is transmitted between the optoelectronic component 104 and the ASIC 102, a length of a passive link experienced by signal transmission is relatively long, and there are a relatively large quantity of soldering nodes. Consequently, loss of the signal in a transmission process is relatively large, and there are a relatively large quantity of parasitic parameters. Therefore, bandwidth for signal transmission may also be limited.

In addition, in the existing optoelectronic apparatus 100, a pad of the FPC 106 and a pad of the second substrate 105 are soldered by using solder. Because the FPC 106 is usually made of an organic material, and the second substrate 105 is usually made of a ceramic material, dielectric constants of the two materials vary greatly. When the FPC 106 is connected to the optoelectronic component, a packaging mode mismatch usually occurs. Therefore, bandwidth for signal transmission may also be limited.

In conclusion, in the existing optoelectronic apparatus 100, bandwidth for signal transmission is relatively low, and therefore signal transmission performance is relatively poor.

For a problem existing in the foregoing existing optoelectronic apparatus 100, FIG. 2 is a schematic diagram (side view) of a structure of an optoelectronic apparatus 200 according to an embodiment of this application.

As shown in FIG. 2, the optoelectronic apparatus 200 includes a PCB 201, an ASIC 202, a first substrate 203, an optoelectronic component 204, a second substrate 205, and an FPC 206. The first substrate 203 and the second substrate 205 are separately disposed on the PCB 201. The ASIC 202 is disposed on the first substrate 203. The optoelectronic component 204 is disposed on the second substrate 205. A first end of the FPC 206 is disposed on an upper surface of the first substrate 203 and is electrically connected to the ASIC 202, and a second end of the FPC 206 is disposed on an upper surface of the second substrate 205 and is electrically connected to the optoelectronic component 204.

Based on the optoelectronic apparatus 200 provided in this embodiment of this application, the ASIC 202 and the optoelectronic component 204 may be electrically connected directly by using a circuit cable on the FPC 206. In other words, a signal of the optoelectronic component 204 may be directly transmitted, by using the circuit cable on the FPC 206, to the ASIC 202 disposed on the PCB 201 without using the PCB 201, so that a length of a passive link experienced by signal transmission and a quantity of soldering nodes can be reduced. In this way, parasitic parameters of the signal in a transmission process can be reduced, and loss of the signal can be reduced. Therefore, bandwidth for signal transmission can be improved, and signal transmission performance is improved.

It should be noted that the PCB is a printed circuit board, and is also referred to as a rigid circuit board. The PCB is a support of an electronic component or a carrier that is electrically connected to the electronic component.

It should be further noted that the FPC is a flexible printed circuit. The FPC is a highly reliable flexible printed circuit made of a flexible insulating substrate such as polyimide or a polyester film, and is characterized by high wiring density, light weight, thin thickness, and good bendability. The FPC is mainly used in an electronic product. As all lines are configured on the FPC, connections of extra line cables can be eliminated, and softness can be improved. In addition, the FPC can absorb an assembly tolerance and strengthen three-dimensional space assembly in limited space to reduce a product volume.

Optionally, there may be a plurality of types of optoelectronic components 204. This is not limited in this embodiment of this application.

In a possible implementation, the optoelectronic component 204 may be an optoelectronic chip, and the optoelectronic chip is a core component of optical communication. For example, the optoelectronic chip may be a module that has an optoelectronic signal conversion function. In addition, the optoelectronic chip may further have a function such as modulation. For details, refer to the prior art. This is not specifically limited in this embodiment of this application.

In a possible implementation, that the ASIC 202 is disposed on the first substrate 203 may be understood as that the ASIC 202 is packaged or mounted on the first substrate 203.

Optionally, the ASIC 202 may be mounted on the first substrate 203 in a plurality of manners. This is not limited in this embodiment of this application.

In a possible implementation, as shown in FIG. 2, the ASIC 202 and the first substrate 203 may be soldered by using a first ball grid array (ball grid array, BGA) 207.

For example, FIG. 3 (a top view) and FIG. 4 (a side view) are schematic diagrams of a connection between the AIC 202 and the first substrate 203. As shown in FIG. 3 and FIG. 4, a first pad 208 is disposed on a lower surface of the ASIC 202, a second pad 209 is disposed on an upper surface of the first substrate 203, and the first pad 208 and the second pad 209 are soldered by using the first BGA 207.

In a possible implementation, that the optoelectronic component 204 is disposed on the second substrate 205 may be understood as that the optoelectronic component 204 is packaged or mounted on the second substrate 205.

It should be noted that for a manner of mounting the optoelectronic component 204 on the second substrate 205, refer to a manner of mounting the ASIC 202 on the first substrate 203 described in FIG. 3 and FIG. 4. To avoid repetition, details are not described herein again.

Optionally, the second substrate 205 may alternatively be a package base or a base. In this embodiment of this application, only the substrate is used as an example for description. However, this embodiment of this application is not limited thereto.

Optionally, the first end of the FPC may be electrically connected to the first substrate in a plurality of manners. This is not limited in this embodiment of this application.

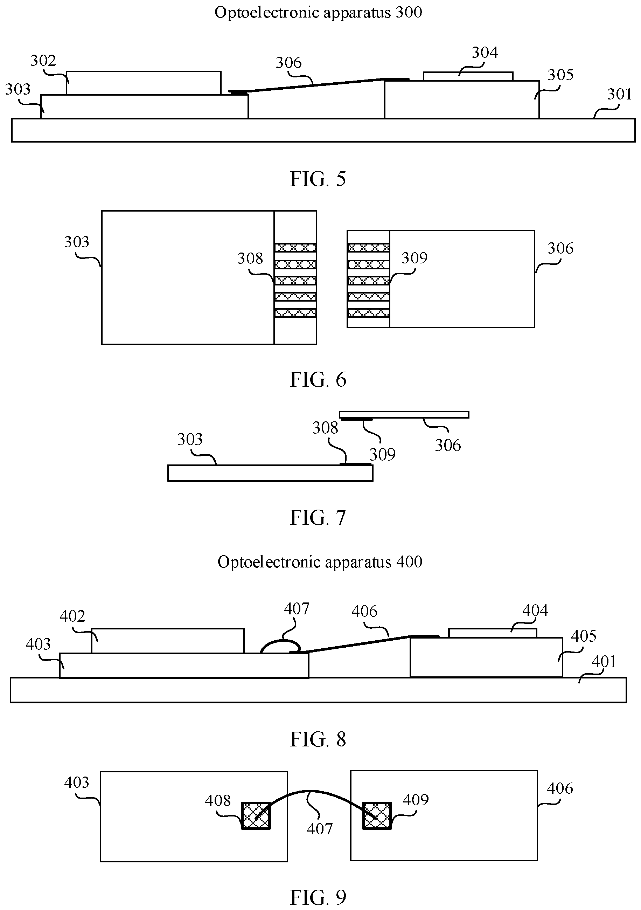

A possible manner of electrically connecting the first end of the FPC and the first substrate is described below with reference to FIG. 5 to FIG. 7. It should be noted that for a part that is not described in detail in FIG. 5, refer to descriptions of a corresponding part in FIG. 2. To avoid repetition, details are not described herein again.

FIG. 5 is a schematic diagram (side view) of a structure of an optoelectronic apparatus 300 according to an embodiment of this application. As shown in FIG. 5, a first end of the FPC 306 and the first substrate 303 are soldered.

For example, FIG. 6 (a top view) and FIG. 7 (a side view) are schematic diagrams of a connection between a first end of the FPC 306 and the first substrate 303. As shown in FIG. 6 and FIG. 7, a third pad 308 is disposed on an upper surface of the first substrate 303, a fourth pad 309 is disposed on a lower surface of the first end of the FPC 306, and the third pad 308 and the fourth pad 309 are soldered.

Optionally, the first end of the FPC 306 and the first substrate 303 may be soldered by using a tin-based solder by using an existing PCB or FPC soldering process, for example, soldering process such as hot bar soldering or laser. This is not limited in this embodiment of this application.

Another possible manner of electrically connecting the first end of the FPC and the first substrate is described below with reference to FIG. 8 to FIG. 10. It should be noted that for a part that is not described in detail in FIG. 8, refer to descriptions of a corresponding part in FIG. 2. To avoid repetition, details are not described herein again.

FIG. 8 is a schematic diagram (side view) of a structure of an optoelectronic apparatus 400 according to an embodiment of this application. As shown in FIG. 8, the optoelectronic apparatus 400 further includes a first bonding wire 407, and a first end of the FPC 406 and the first substrate 403 are soldered by using the first bonding wire 407.

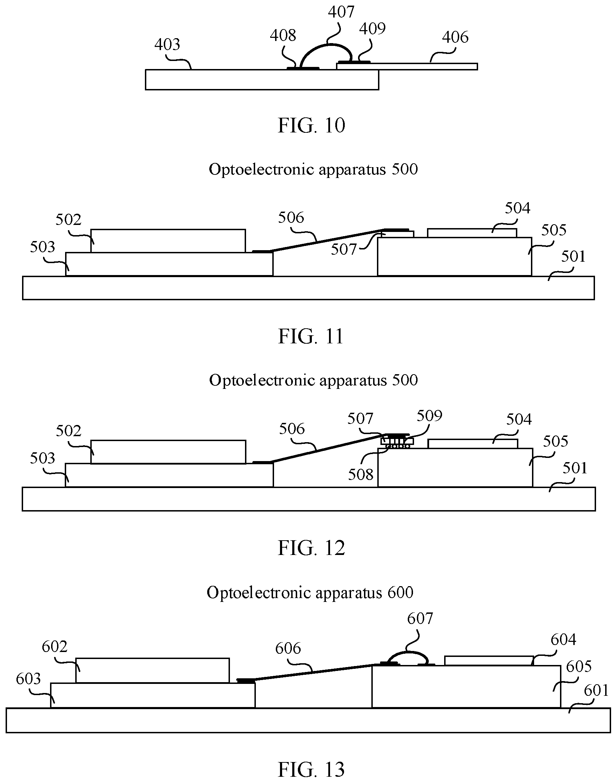

For example, FIG. 9 (a top view) and FIG. 10 (a side view) are schematic diagrams of a connection between a first end of the FPC 406 and the first substrate 403. As shown in FIG. 9 and FIG. 10, a fifth pad 408 is disposed on an upper surface of the first substrate 403, a sixth pad 409 is disposed on an upper surface of the first end of the FPC 406, and the fifth pad 408 and the sixth pad 409 are electrically connected by using the first bonding wire 407.

Optionally, a second end of the FPC may be electrically connected to the second substrate in a plurality of manners. This is not limited in this embodiment of this application.

A possible manner of electrically connecting the second end of the FPC and the second substrate is described below with reference to FIG. 11 to FIG. 12. It should be noted that for a part that is not described in detail in FIG. 11 and FIG. 12, refer to descriptions of a corresponding part in FIG. 2, FIG. 5, and/or FIG. 8. To avoid repetition, details are not described herein again.

FIG. 11 is a schematic diagram (side view) of a structure of an optoelectronic apparatus 500 according to an embodiment of this application. As shown in FIG. 11, the optoelectronic apparatus 500 includes a third substrate 507, a second end of the FPC 506 is disposed on an upper surface of the third substrate 507, the second substrate 505 is disposed on a lower surface of the third substrate 507, the third substrate 507 is configured to electrically connect the FPC 506 to an optoelectronic component 504, and a difference between a dielectric constant of a material of the third substrate 507 and a dielectric constant of a material of the FPC 506 is less than a preset dielectric constant threshold.

In other words, the material of the third substrate 507 is close to or the same as the material of the FPC 506.

For example, as shown in FIG. 12, the upper surface of the third substrate 507 is soldered to a lower surface of the second end of the FPC 506, the lower surface of the third substrate 507 is soldered to the upper surface of the second substrate 505 by using a second BGA 508, and the upper surface of the third substrate 507 is electrically connected to the lower surface of the third substrate 507 by using at least one through-hole 509.

It should be noted that the through-hole is also referred to as a plated hole. In a double-sided substrate and a multi-layer substrate, to connect printed wires between layers, a common hole, that is, a through-hole, is drilled at an intersection of wires that need to be connected to the layers.

It should be further noted that for a manner of connecting the upper surface of the third substrate 507 to the lower surface of the second end of the FPC 506, refer to a manner of connecting the lower surface of the first end of the FPC 306 to the upper surface of the first substrate 303 in FIG. 6 and FIG. 7. For a manner of connecting the lower surface of the third substrate 507 to the upper surface of the second substrate 505 by using the second BGA 508, refer to the manner of connecting the ASIC 202 to the first substrate 203 by using the first BGA 207 in FIG. 3 and FIG. 4. To avoid repetition, details are not described herein again.

It should be noted that in a conventional technology, because the FPC and the ceramic second substrate belong to a PCB/FPC packaging process, the dielectric constant of the material of the FPC and a material of the ceramic second substrate are relatively different differ to a relatively large extent. A packaging mode mismatch usually occurs when the FPC is connected to the optoelectronic component. Therefore, bandwidth for signal transmission is limited.

In this embodiment of this application, the material of the FPC 506 is close to or the same as the material of the third substrate 507, so that a problem of limited bandwidth for signal transmission caused by a material difference between the FPC 506 and the third substrate 507 can be avoided. In addition, because the third substrate 507 and the second substrate 505 are inter-substrate packaging, a packaging process with higher precision such as solder ball flip chip (solder ball flip chip) or copper pillar flip chip (copper pillar flip chip) may be used, to absorb an assembly tolerance between different materials, so that a problem of limited bandwidth for signal transmission caused by a material difference between the third substrate 507 and the second substrate 505 can be avoided. Therefore, the third substrate 507 is electrically connected to the FPC 506 and the second substrate 505, so that bandwidth for signal transmission can be improved.

Another possible manner of electrically connecting the second end of the FPC and the second substrate is described below with reference to FIG. 13. It should be noted that for a part that is not described in detail in FIG. 13, refer to descriptions of a corresponding part in FIG. 2, FIG. 5, and/or FIG. 8. To avoid repetition, details are not described herein again.

FIG. 13 is a schematic diagram (side view) of a structure of an optoelectronic apparatus 600 according to an embodiment of this application. As shown in FIG. 13, the optoelectronic apparatus 600 includes a second bonding wire 607, and a second end of the FPC 606 and the second substrate 605 are soldered by using the second bonding wire 607.

It should be noted that for a manner of connecting the second end of the FPC 606 to the second substrate 605 by using the second bonding wire 607, refer to a manner of connecting the first end of the FPC 406 to the first substrate 403 by using the first bonding wire 407 in FIG. 9 and FIG. 10. To avoid repetition, details are not described herein again.

Based on the optoelectronic apparatus 600 provided in this application, the FPC 606 is connected to the second substrate 605 by using the second bonding wire 607; in other words, a soldering process does not need to be used for connection, so that a problem of limited bandwidth for signal transmission caused by a material difference between the FPC 606 and the second substrate 605 in a conventional technology can be avoided.

It should be noted that the foregoing various provided connection manners between the first end of the FPC and the substrate and the connection manners between the second end of the FPC and the second substrate may be randomly combined. This is not limited in this embodiment of this application.

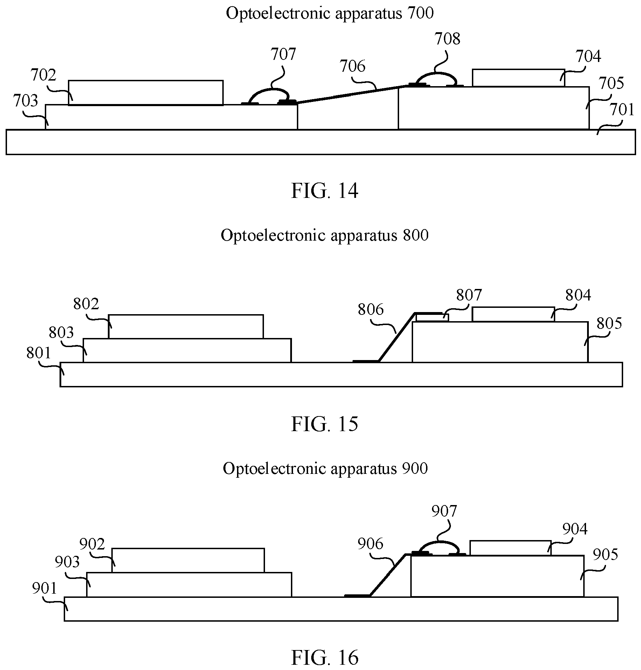

For example, FIG. 14 is a schematic diagram (side view) of a structure of an optoelectronic apparatus 700 according to an embodiment of this application. As shown in FIG. 14, the optoelectronic apparatus 700 further includes a third bonding wire 707 and a fourth bonding wire 708, a first end of the FPC 706 is connected to the substrate 703 by using the third bonding wire 707, and a second end of the FPC 706 is connected to the second substrate 705 by using the fourth bonding wire 708.

It should be noted that, for a manner of connecting the first end of the FPC 706 to the substrate 703 by using the third bonding wire 707 and a manner of connecting the second end of the FPC 706 to the second substrate 705 by using the fourth bonding wire 708, refer to a manner of connecting the first end of the FPC 406 to the first substrate 403 by using the first bonding wire 407 in FIG. 9 and FIG. 10. To avoid repetition, details are not described herein again.

It should be further noted that for a part that is not described in detail in FIG. 14, refer to descriptions of a corresponding part in FIG. 2. To avoid repetition, details are not described herein again.

FIG. 15 is a schematic diagram (side view) of a structure of an optoelectronic apparatus 800 according to an embodiment of this application. As shown in FIG. 15, the optoelectronic apparatus 800 includes a PCB 801, an ASIC 802, a first substrate 803, an optoelectronic component 804, a second substrate 805, an FPC 806, and a third substrate 807. The first substrate 803 and the second substrate 805 are separately disposed on the PCB 801. The ASIC 802 is disposed on the first substrate 803. A first end of the FPC 806 is disposed on an upper surface of the PCB 801 and is electrically connected to the ASIC 802 disposed on the first substrate 803, and a second end of the FPC 806 is disposed on an upper surface of the third substrate 807. The second substrate 805 is disposed on a lower surface of the third substrate 807. The third substrate 807 is configured to electrically connect the FPC 806 to the optoelectronic component 804. A difference between a dielectric constant of a material of the third substrate 807 and a dielectric constant of a material of the FPC 806 is less than a preset dielectric constant threshold.

In other words, the optoelectronic component 804 is connected to the FPC 806 by using an interposer of the third substrate 807, and is electrically connected to the ASIC 802 by using a circuit cable on the PCB 801 by using the FPC 806, and the material of the third substrate 807 is close to or the same as the material of the FPC 806. In this way, a problem of limited bandwidth for signal transmission caused by a material difference between the FPC 806 and the second substrate 804 can be avoided.

It should be noted that for each part in the optoelectronic apparatus 800 and a connection manner of the parts, refer to the foregoing corresponding descriptions. To avoid repetition, details are not described herein again.

Optionally, FIG. 16 is a schematic diagram (side view) of a structure of an optoelectronic apparatus 900 according to an embodiment of this application. As shown in FIG. 16, the optoelectronic apparatus 900 includes a PCB 901, an ASIC 902, a first substrate 903, an optoelectronic component 904, a second substrate 905, an FPC 906, and a fifth bonding wire 907. The first substrate 903 and the second substrate 905 are separately disposed on the PCB 901. The ASIC 902 is disposed on the first substrate 903. A first end of the FPC 906 is disposed on an upper surface of the PCB 901 and is electrically connected to the ASIC 902 disposed on the first substrate 903. A first end of the fifth bonding wire 907 is disposed on a second end of the FPC 906, a second end of the fifth bonding wire 907 is disposed on an upper surface of the second substrate 905, and the fifth bonding wire 907 is configured to electrically connect the FPC 906 to the optoelectronic component 904.

In other words, the optoelectronic component 904 is connected to the FPC 906 by using the fifth bonding wire 907, and is electrically connected to the ASIC 902 by using a circuit cable on the PCB 901 by using the FPC 906. In this way, a problem of limited bandwidth for signal transmission caused by a material difference between the FPC 906 and the second substrate 904 can be avoided.

The optoelectronic apparatus provided in embodiments of this application is described above with reference to FIG. 2 to FIG. 16. An optoelectronic integration method provided in embodiments of this application is described below with reference to the following steps 1 to 4.
Step 1: Mount an ASIC on a first substrate.
Step 2: Mount an optoelectronic component on a second substrate.
Step 3: Mount the first substrate and the second substrate on a PCB.
Step 4: Dispose a first end of an FPC on the first substrate and electrically connect the first end of the FPC to the ASIC on the first substrate.
Step 5: Dispose a second end of the FPC on the second substrate and electrically connect the second end of the FPC to the optoelectronic component on the second substrate.

It should be noted that for an implementation process of step 4 and step 5, refer to descriptions of a corresponding part in the foregoing apparatus embodiments.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An optoelectronic apparatus, comprising:
a printed circuit board PCB, wherein
a first substrate and a second substrate are separately disposed on the PCB;
an application specific integrated circuit ASIC is disposed on the first substrate; and
an optoelectronic component is disposed on the second substrate; and
a flexible printed circuit FPC, wherein a first end of the FPC is disposed on an upper surface of the first substrate and is electrically connected to the ASIC, and a second end of the FPC is disposed on the second substrate and is electrically connected to the optoelectronic component.

2. The optoelectronic apparatus according to claim 1, wherein the optoelectronic apparatus further comprises a third substrate, the second end of the FPC is disposed on an upper surface of the third substrate, the second substrate is disposed on a lower surface of the third substrate, the third substrate is configured to electrically connect the FPC to the optoelectronic component, and a difference between a dielectric constant of a material of the third substrate and a dielectric constant of a material of the FPC is less than a preset dielectric constant threshold.

3. The optoelectronic apparatus according to claim 2, wherein the upper surface of the third substrate is electrically connected to the second end of the FPC, the lower surface of the third substrate is electrically connected to the upper surface of the second substrate, and the upper surface of the third substrate is electrically connected to the lower surface of the third substrate by using at least one through-hole.

4. The optoelectronic apparatus according to claim 3, wherein the upper surface of the third substrate is soldered to the second end of the FPC.

5. The optoelectronic apparatus according to claim 3 or 4, wherein the lower surface of the third substrate and the upper surface of the second substrate are soldered by using a first ball grid array BGA.

6. The optoelectronic apparatus according to claim 1, wherein the optoelectronic apparatus further comprises a first bonding wire, and the first bonding wire is configured to electrically connect the second end of the FPC to the second substrate.

7. The optoelectronic apparatus according to any one of claims 1 to 6, wherein the first end of the FPC is soldered to the upper surface of the first substrate.

8. The optoelectronic apparatus according to any one of claims 1 to 6, wherein the optoelectronic apparatus further comprises a second bonding wire, and the second bonding wire is configured to electrically connect the first end of the FPC to the first substrate.

9. The optoelectronic apparatus according to any one of claims 1 to 6, wherein the material of the FPC is an organic material, and a material of the second substrate is ceramic.

10. An optoelectronic apparatus, comprising:
a printed circuit board PCB, wherein
a first substrate and a second substrate are separately disposed on the PCB;
an application specific integrated circuit ASIC is disposed on the first substrate; and
an optoelectronic component is disposed on the second substrate; and
a flexible printed circuit FPC and a third substrate, wherein
a first end of the FPC is disposed on an upper surface of the PCB and is electrically connected to the ASIC disposed on the first substrate, a second end of the FPC is disposed on an upper surface of the third substrate, the second substrate is disposed on a lower surface of the third substrate, and the third substrate is configured to electrically connect the FPC to the optoelectronic component; and
a difference between a dielectric constant of a material of the third substrate and a dielectric constant of a material of the FPC is less than a preset dielectric constant threshold.

11. The optoelectronic apparatus according to claim 10, wherein the upper surface of the third substrate is electrically connected to the second end of the FPC, the lower surface of the third substrate is electrically connected to the upper surface of the second substrate, and the upper surface of the third substrate is electrically connected to the lower surface of the third substrate by using at least one through-hole.

12. The optoelectronic apparatus according to claim 11, wherein the upper surface of the third substrate is soldered to the second end of the FPC.

13. The optoelectronic apparatus according to claim 11 or 12, wherein the lower surface of the third substrate and the upper surface of the second substrate are soldered by using a first ball grid array BGA.

14. The optoelectronic apparatus according to any one of claims 11 to 13, wherein the material of the FPC is an organic material, and a material of the second substrate is ceramic.

15. An optoelectronic apparatus, comprising:
a printed circuit board PCB, wherein
a first substrate and a second substrate are separately disposed on the PCB;
an application specific integrated circuit ASIC is disposed on the first substrate; and
an optoelectronic component is disposed on the second substrate; and
a flexible printed circuit FPC and a bonding wire, wherein
a first end of the FPC is disposed on an upper surface of the PCB and is electrically connected to the ASIC disposed on the first substrate, a first end of the bonding wire is disposed on a second end of the FPC, a second end of the bonding wire is disposed on an upper surface of the second substrate, and the bonding wire is configured to electrically connect the FPC to the optoelectronic component.

16. The optoelectronic apparatus according to claim 15, wherein a material of the FPC is an organic material, and a material of the second substrate is ceramic.
